# EUROPEAN PATENT SPECIFICATION

(11) **EP 3 291 294 B1**
(45) Date of publication and mention of the grant of the patent: **24.08.2022**
(21) Application number: 17174442.8
(22) Date of filing: 05.06.2017
(51) Int. Cl.: H01L 23/373, H01L 23/42, B82Y 30/00, B82Y 40/00

(54) **HEAT DISSIPATION STRUCTURE USING GRAPHENE QUANTUM DOTS AND METHOD OF MANUFACTURING THE HEAT DISSIPATION STRUCTURE**
WÄRMEABLEITUNGSSTRUKTUR UNTER VERWENDUNG VON GRAPHEN-QUANTENPUNKTEN UND VERFAHREN ZUR HERSTELLUNG DER WÄRMEABLEITUNGSSTRUKTUR
STRUCTURE DE DISSIPATION DE CHALEUR AU MOYEN DE POINTS QUANTIQUES DE GRAPHÈNE ET PROCÉDÉ DE FABRICATION DE LA STRUCTURE DE DISSIPATION DE CHALEUR

(30) Priority: 23.08.2016 KR 20160106980
(43) Date of publication of application: 07.03.2018
(73) Proprietor: Samsung Electronics Co., Ltd., Gyeonggi-do 16677 (KR)
(72) Inventor: LEE, Dongwook, 16678 Gyeonggi-do (KR); KIM, Sangwon, 16678 Gyeonggi-do (KR); SEOL, Minsu, 16678 Gyeonggi-do (KR); JEONG, Seongjun, 16678 Gyeonggi-do (KR); NAM, Seunggeol, 16678 Gyeonggi-do (KR); PARK, Seongjun, 16678 Gyeonggi-do (KR); SHIN, Hyeonjin, 16678 Gyeonggi-do (KR)
(74) Representative: Elkington and Fife LLP

(56) References cited:
- WO-A1-2016/004565
- CN-A- 105 449 067
- DE-A1-102011 083 126
- US-A1- 2010 085 713
- US-A1- 2013 264 041
- US-A1- 2014 264 820
- US-A1- 2014 287 239
- KHAN M F SHAHIL ET AL: "Thermal properties of graphene and multilayer graphene: Applications in thermal interface materials", SOLID STATE COMMUNICATIONS, PERGAMON, GB, vol. 152, no. 15, 12 April 2012 (2012-04-12), pages 1331-1340, XP028402271, ISSN: 0038-1098, DOI: 10.1016/J.SSC.2012.04.034 [retrieved on 2012-04-25]
- KHAN M. F. SHAHIL ET AL: "Graphene-Multilayer Graphene Nanocomposites as Highly Efficient Thermal Interface Materials", NANO LETTERS, vol. 12, no. 2, 8 February 2012 (2012-02-08), pages 861-867, XP055056589, ISSN: 1530-6984, DOI: 10.1021/nl203906r
- MITCHELL BACON ET AL: "Graphene Quantum Dots", PARTICLE & PARTICLE SYSTEMS CHARACTERIZATION, vol. 31, no. 4, 27 November 2013 (2013-11-27), pages 415-428, XP055136808, ISSN: 0934-0866, DOI: 10.1002/ppsc.201300252

## Description

### FIELD OF THE INVENTION

The present disclosure relates to heat dissipation structures using graphene quantum dots (GQDs) and/or methods of manufacturing the heat dissipation structures.

### BACKGROUND OF THE INVENTION

A semiconductor chip includes a plurality of semiconductor devices that generate heat due to operations thereof. To dissipate heat generated from the semiconductor devices, to outside, a heat dissipation film may be bonded to a top surface of the semiconductor chip. In general, an adhesive layer may be used between the semiconductor chip and the heat dissipation film to bond the heat dissipation film to the semiconductor chip. However, the adhesive layer may reduce heat dissipation efficiency.

KHAN M F SHAHIL ET AL: "Thermal properties of graphene and multilayer graphene: Applications in thermal interface materials", SOLID STATE COMMUNICATIONS, PERGAMON, GB, vol. 152, no.15, 12 April 2012, pages 1331-1340, XP028402271 discloses a heat dissipation structure according to the precharacterizing part of claim 1.

US2014/264820A discloses a method of making paste thermal interface materials, according to the precharacterizing part of claim 11.

### SUMMARY OF THE INVENTION

The invention is defined in the claims.

Provided are heat dissipation structures using graphene quantum dots (GQDs) and a method of manufacturing the heat dissipation structures.

Additional aspects will be set forth in part in the description which follows and, in part, will be apparent from the description, or may be learned by practice of the presented embodiments.

According to some example embodiments, a heat dissipation structure includes a heating element, and a heat dissipation film on the heating element to dissipate heat generated from the heating element, to outside. The heat dissipation film includes nano-sized graphene fragments. Each of the nano-sized graphene fragments has at least one of: a disc shape; a thickness of 1 nm to 2 nm; and a diameter of 3 nm to 4 nm.

The nano-sized graphene fragments may comprise graphene quantum dots (GQDs).

In some example embodiments, the heat dissipation film may further include at least one of graphene, carbon nanotubes (CNTs), and graphene oxide.

In some example embodiments, the heating element may include a semiconductor chip. The semiconductor chip may include one or more semiconductor devices capable of generating heat due to operations thereof. In this case, the heat dissipation film may be on the semiconductor chip to dissipate heat generated from the one or more semiconductor devices, to outside.

In some example embodiments, the semiconductor chip may further include a semiconductor substrate on the one or more semiconductor devices. A first surface of the semiconductor substrate may be on the one or more semiconductor devices, and the heat dissipation film may be provided on a second surface of the semiconductor substrate opposite to the first surface. In this case, the heat dissipation film may directly contact the second surface of the semiconductor substrate.

In some example embodiments, the heat dissipation structure may further include a package substrate bonded to the semiconductor chip.

In some example embodiments, the heat dissipation film may have a thickness of 50 nm to 35 *µ*m. Each of the GQDs may have a disc shape having a thickness of 1 nm to 2 nm and a diameter of 3 nm to 4 nm.

According to some example embodiments, a method of manufacturing a heat dissipation structure includes coating a solution including nano-sized graphene fragments on a surface of a heating element, and forming a heat dissipation film on the surface of the heating element by drying the solution including graphene fragments. The graphene fragments are nano-sized, and each of the graphene fragments has at least one of: a disc shape; a thickness of 1 nm to 2 nm; and a diameter of 3 nm to 4 nm.

In some example embodiments, the solution may further include at least one of graphene, carbon nanotubes (CNTs), and graphene oxide.

In some example embodiments, the solution may be coated using one of spin coating, screen printing, and a doctor blade method.

In some example embodiments, the heating element may include a semiconductor chip including one or more semiconductor devices capable of generating heat due to operations thereof. The semiconductor chip may further include a semiconductor substrate on the one or more semiconductor devices.

In some example embodiments, a first surface of the semiconductor substrate may be one the one or more semiconductor devices, and the heat dissipation film may be on a second surface of the semiconductor substrate opposite to the first surface. The heat dissipation film may directly contact the second surface of the semiconductor substrate. The semiconductor chip may be bonded to a package substrate.

According to some example embodiments, a heat dissipation structure includes heating element and a heat dissipation film on the heating element to dissipate heat generated from the heating element, to outside. The heat dissipation film includes nano-sized graphene fragments.

In some example embodiments, the nano-sized graphene fragments may be graphene quantum dots (GQDs), and the heat dissipation film may further include at least one of carbon nanotubes (CNTs) and graphene oxide.

In some example embodiments, the heating element may include a semiconductor chip, and the semiconductor chip may include one or more semiconductor devices capable of generating heat due to operations thereof.

In some example embodiments, the semiconductor chip may further include a semiconductor substrate, and the heat dissipation film may directly contact the semiconductor substrate.

In some example embodiments, the heat dissipation structure may further include a package substrate bonded to the semiconductor chip.

### BRIEF DESCRIPTION OF THE DRAWINGS

These and/or other aspects will become apparent and more readily appreciated from the following description of the presented embodiments, taken in conjunction with the accompanying drawings in which:
FIG. 1 is a cross-sectional view of a heat dissipation structure according to some example embodiments;
FIGS. 2A and 2B are scanning electron microscopic (SEM) images of graphene quantum dots (GQDs);
FIG. 3 is a cross-sectional view of a heat dissipation structure according to some example embodiments;
FIG. 4 is a cross-sectional view of a heat dissipation structure according to some example embodiments;
FIGS. 5A to 5C are cross-sectional views for describing a method of manufacturing a heat dissipation structure according to some example embodiments;
FIGS. 6A to 6C are cross-sectional views for describing a method of manufacturing a heat dissipation structure according to some example embodiments;
FIGS. 7 and 8 are cross-sectional views of energy conversion devices that include a heat-dissipation film according to some example embodiments; and
FIGS. 9A and 9B are cross-sectional views of thermoelectric devices that include a heat dissipation film according to some example embodiments.

### DETAILED DESCRIPTION

Example embodiments will now be described more fully with reference to the accompanying drawings, in which some example embodiments are shown. Example embodiments, may, however, be embodied in many different forms and should not be construed as being limited to the embodiments set forth herein; rather, these example embodiments are provided so that this disclosure will be thorough and complete, and will fully convey the scope of example embodiments of inventive concepts to those of ordinary skill in the art. Expressions such as "at least one of," when preceding a list of elements, modify the entire list of elements and do not modify the individual elements of the list.

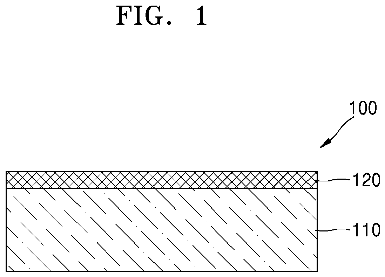

FIG. 1 is a cross-sectional view of a heat dissipation structure 100 according to some example embodiments.

Referring to FIG. 1, the heat dissipation structure 100 includes a heating element 110 and a heat dissipation film 120 provided on the heating element 110. Herein, the heating element 110 may include one or more devices that generate heat due to operations thereof. The heating element 110 may be a semiconductor chip including one or more semiconductor devices, which will be described below, but is not limited thereto.

The heat dissipation film 120 dissipates heat generated from the heating element 110, to outside, and may include nano-sized graphene fragments, for example graphene quantum dots (GQDs). Due to chemical and physical properties thereof, e.g., a high electrical conductivity, a high surface area, an excellent corrosion resistance, and a high chemical stability, GQDs are used in a variety of technical fields, e.g., bio-imaging, drug delivery, photodetectors, solar cells, and biosensors. Hereinafter, a non-limiting example where the heating element 110 includes GQDs is described, but inventive concepts are not limited thereto.

Each of the GQDs may have a multilayer structure. For example, each GQD may have a multilayer structure of about ten or less layers (e.g., about two to about ten layers, and/or about five to about ten layers), but are not limited thereto. GQDs may be produced using, for example, electron beam lithography, chemical synthesis, or a hydrothermal method.

Each of the GQDs may have a nano-sized disc shape. For example, the GQDs may have a diameter of about 10 nm to 60 nm. For example, the GQDs may have a diameter of about 3 nm to 4 nm and a thickness of about 1 nm to 2 nm. However, the above-mentioned diameter and thickness are merely examples, and the GQDs may have various diameters and thicknesses.

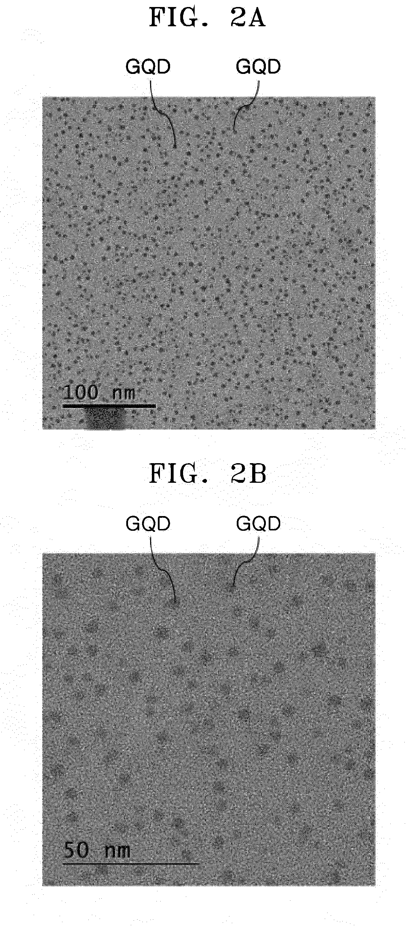

FIG. 2A is a scanning electron microscopic (SEM) image of a heat dissipation film including GQDs. FIG. 2B is a magnified SEM image of FIG. 2A.

The heat dissipation film shown in FIGS. 2A and 2B may be produced by coating a solution including GQDs on a surface of a heating element and then drying the solution, which will be described below. Referring to FIGS. 2A and 2B, a plurality of GQDs are randomly distributed.

Since the heat dissipation film 120 including the GQDs is used, excellent heat dissipation properties may be achieved. The GQDs may have a thermal conductivity of about 1, 000 W/m·K. The GQDs may have excellent heat dissipation properties compared to metal such as copper (Cu). The heat dissipation film 120 including the GQDs may have a thickness of, for example, about 50 nm to 35 *µ*m, but is not limited thereto. If the thickness of the heat dissipation film 120 is excessively small, heat dissipation properties may deteriorate. Otherwise, if the thickness of the heat dissipation film 120 is excessively large, the heat dissipation structure 100 may not have a small thickness.

The heat dissipation film 120 including the GQDs may be provided on at least one surface of the heating element 110. FIG. 1 illustrates a case in which the heat dissipation film 120 is provided on a top surface of the heating element 110. The heat dissipation film 120 may be provided to directly contact the surface of the heating element 110. That is, the heat dissipation film 120 may be provided directly on the surface of the heating element 110 without an adhesive layer intervening therebetween.

In some example embodiments, since the heat dissipation film 120 including the GQDs is used, heat generated from the heating element 110 may be efficiently dissipated to outside. In addition, since the heat dissipation film 120 including the GQDs is provided directly on the surface of the heating element 110 without an adhesive layer intervening therebetween, heat dissipation properties may be improved and the heat dissipation structure 100 may have a small thickness.

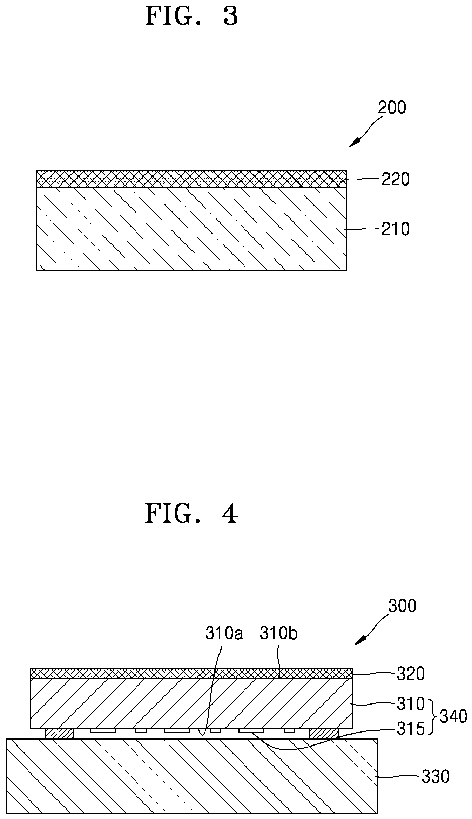

FIG. 3 is a cross-sectional view of a heat dissipation structure 200 according to some example embodiments.

Referring to FIG. 3, the heat dissipation structure 200 includes a heating element 210 and a heat dissipation film 220 provided on the heating element 210. The heat dissipation film 220 may include at least one of nano-sized graphene fragments (e.g., GQDs), graphene, carbon nanotubes (CNTs), and graphene oxide. Each of the GQDs may have a nano-sized disc shape. For example, the GQDs may have a diameter of about 3 nm to 4 nm and a thickness of about 1 nm to 2 nm. However, the GQDs are not limited thereto.

In some example embodiments, in addition to the nano-sized graphene fragments (e.g., GQDs), the heat dissipation film 220 may further include at least one of graphene, CNTs, and graphene oxide. Herein, the graphene, CNTs, or graphene oxide may have excellent heat dissipation properties compared to the GQDs. The heat dissipation film 220 may have a thickness of, for example, about 50 nm to 35 *µ*m , but is not limited thereto.

The heat dissipation film 220 may be provided on at least one surface of the heating element 210. FIG. 3 illustrates a case in which the heat dissipation film 220 is provided on a top surface of the heating element 210. The heat dissipation film 220 may be provided to directly contact the surface of the heating element 210.

In the heat dissipation structure 200 according to some example embodiments, since the heat dissipation film 220 including the at least one of graphene, CNTs, and graphene oxide in addition to the graphene nano-sized fragments (e.g., GQDs) is used, more excellent heat dissipation properties may be achieved. In addition, since the heat dissipation film 220 is provided directly on the surface of the heating element 210 without an adhesive layer intervening therebetween, heat dissipation properties may be improved and the heat dissipation structure 200 may have a small thickness.

FIG. 4 is a cross-sectional view of a heat dissipation structure 300 according to some example embodiments.

Referring to FIG. 4, the heat dissipation structure 300 includes a semiconductor chip 340 and a heat dissipation film 320 provided on the semiconductor chip 340. Herein, the heat dissipation structure 300 may be a semiconductor package.

The semiconductor chip 340 may include a semiconductor substrate 310 and one or more semiconductor devices 315 provided on the semiconductor substrate 310. The semiconductor substrate 310 may be, for example, a silicon substrate. However, the silicon substrate is merely an example and the semiconductor substrate 310 may be a substrate of any of various semiconductor materials. The semiconductor devices 315 may be provided on a first surface 310a of the semiconductor substrate 310 (e.g., a bottom surface of the semiconductor substrate 310 in FIG. 4). The semiconductor devices 315 may generate heat due to operations thereof.

The heat dissipation film 320 dissipates heat generated from the semiconductor devices 315, to outside, and may include graphene nano-sized fragments (e.g., GQDs). Herein, the heat dissipation film 320 including the GQDs may be provided to directly contact a second surface 310b of the semiconductor substrate 310 opposite to the first surface 310a (e.g., a top surface of the semiconductor substrate 310 in FIG. 4).

The heat dissipation film 320 including the GQDs may have a thickness of, for example, about 50 nm to 35 *µ*m, but is not limited thereto. Each of the GQDs included in the heat dissipation film 320 may have a nano-sized disc shape. For example, the GQDs may have a diameter of about 10 nm to 60 nm. Specifically, the GQDs may have a diameter of about 3 nm to 4 nm and a thickness of about 1 nm to 2 nm. However, the GQDs are not limited thereto.

The heat dissipation structure 300 may further include a package substrate 330 bonded to the semiconductor chip 340. Herein, the package substrate 330 may be bonded to a bottom surface of the semiconductor chip 340 on which the semiconductor devices 315 are provided.

In the heat dissipation structure 300, since the GQDs has excellent heat dissipation properties and the heat dissipation film 320 including the GQDs is provided on a top surface of the semiconductor chip 340, heat generated from the semiconductor devices 315 of the semiconductor chip 340 may be efficiently dissipated through the semiconductor substrate 310 and the heat dissipation film 320. In addition, since the heat dissipation film 320 may be provided directly on the top surface of the semiconductor chip 340 without an adhesive layer intervening therebetween, heat dissipation properties may be improved and the heat dissipation structure 300 serving as a semiconductor package may have a small thickness.

In addition to the nano-sized graphene fragments (e.g., GQDs), the heat dissipation film 320 may further include at least one of graphene, CNTs, and graphene oxide. In this case, heat dissipation properties of the heat dissipation film 320 may be further improved.

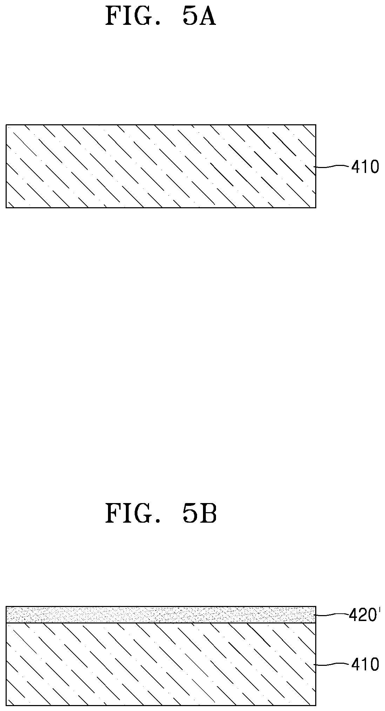

FIGS. 5A to 5C are cross-sectional views for describing a method of manufacturing a heat dissipation structure 400 according to some example embodiments.

Referring to FIG. 5A, a heating element 410 is prepared. Herein, the heating element 410 may include one or more devices that generate heat due to operations thereof. The heating element 410 may be a semiconductor chip including one or more semiconductor devices, but is not limited thereto.

Referring to FIG. 5B, a solution 420' including nano-sized graphene fragments (e.g., GQDs) is coated on the heating element 410. To this end, initially, the solution 420' including the nano-sized graphene fragments (e.g., GQDs) is produced. A non-limiting example where the solution 420' includes GQDs is described. The solution 420' may be produced by mixing the GQDs in a solvent. The solvent used herein may be, for example, N-methyl-2-pyrrolidone (NMP), NH₄OH, or dimethylformamide (DMF), but is not limited thereto. The density of the GQDs in the solution 420' may be, for example, about 20 weight percent (wt%). However, the density of the GQDs is not limited thereto and may be variously changed.

Then, the solution 420' including the GQDs is coated on the heating element 410. The solution 420' may be coated on at least one surface of the heating element 410. Herein, the solution 420' including the GQDs may be coated using, for example, spin coating, screen printing, or a doctor blade method.

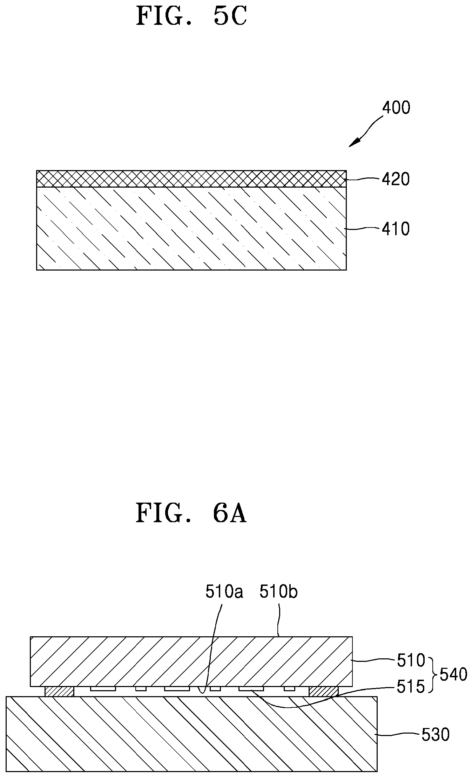

Referring to FIG. 5C, the heat dissipation structure 400 is produced by forming a heat dissipation film 420 including GQDs, on the heating element 410. The heat dissipation film 420 may be formed by drying the solution 420' including the GQDs and coated on the heating element 410, to remove the solvent. As such, the heat dissipation film 420 including the GQDs may be formed to directly contact the surface of the heating element 410.

In the above description, the heat dissipation film 420 may be produced by coating the solution 420' including the GQDs, on the surface of the heating element 410 and drying the solution 420'. Alternatively, a solution including at least one of graphene, CNTs, and graphene oxide in addition to nano-sized graphene fragments (e.g., GQDs) may be coated on the surface of the heating element 410, and then dried. In this case, a heat dissipation film including GQDs and at least one of graphene, CNTs, and graphene oxide may be formed on the surface of the heating element 410.

FIGS. 6A to 6C are cross-sectional views for describing a method of manufacturing a heat dissipation structure 500 according to some example embodiments.

Referring to FIG. 6A, a semiconductor chip 540 is prepared. Herein, the semiconductor chip 540 may include a semiconductor substrate 510 and one or more semiconductor devices 515 provided on the semiconductor substrate 510. The semiconductor chip 540 may be produced by cutting a semiconductor wafer having mounted the semiconductor devices 515 thereon.

The semiconductor substrate 510 may be, for example, a silicon substrate. However, the silicon substrate is merely an example and the semiconductor substrate 510 may be a substrate of any of various semiconductor materials. The semiconductor devices 515 may be provided on a first surface 510a of the semiconductor substrate 510 (e.g., a bottom surface of the semiconductor substrate 510 in FIG. 6A). The semiconductor devices 515 may generate heat due to operations thereof. The semiconductor chip 540 may be bonded to a package substrate 530. The package substrate 530 may be bonded to a bottom surface of the semiconductor chip 540 on which the semiconductor devices 515 are provided.

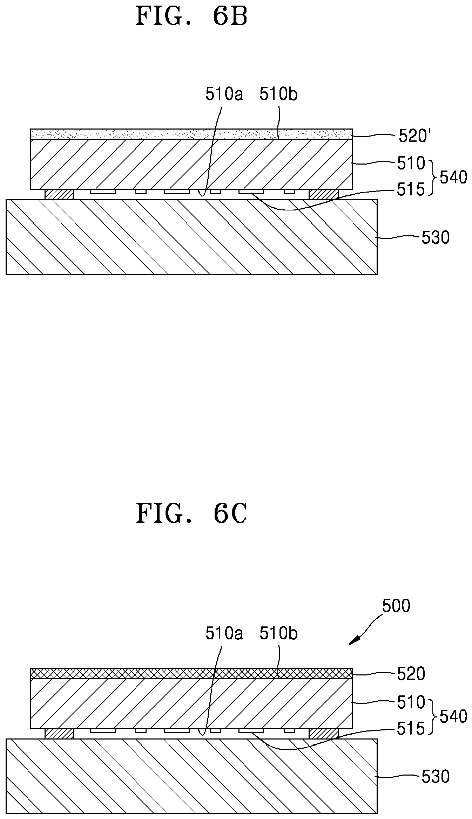

Referring to FIG. 6B, a solution 520' including nano-sized graphene fragments (e.g., GQDs) may be coated on a surface of the semiconductor chip 540. For ease of description, an example where the nano-sized graphene fragments are GQDs is described. To this end, initially, the solution 520' including GQDs is produced. The solution 520' may be produced by mixing the GQDs in a solvent. The solvent used herein may be, for example, N-methyl-2-pyrrolidone (NMP), NH₄OH, or dimethylformamide (DMF), but is not limited thereto. The density of the GQDs in the solution 520' may be, for example, about 20 weight percent (wt%), but is not limited thereto.

Then, the solution 520' including the GQDs is coated on the semiconductor chip 540. Herein, the solution 520' including the GQDs may be coated on a second surface 510b of the semiconductor substrate 510 opposite to the first surface 510a (e.g., a top surface of the semiconductor substrate 510 in FIG. 6B). The solution 520' including the GQDs may be coated using, for example, spin coating, screen printing, or a doctor blade method.

Referring to FIG. 6C, a heat dissipation film 520 including GQDs is formed on a top surface of the semiconductor chip 540. The heat dissipation film 520 may be formed by drying the solution 520' including the GQDs and coated on the semiconductor chip 540, to remove the solvent. As such, the heat dissipation film 520 including the GQDs may be formed to directly contact the top surface of the semiconductor substrate 510.

In the above description, the heat dissipation film 520 is produced by coating the solution 520' including the GQDs, on the top surface of the semiconductor chip 540 and drying the solution 520'. Alternatively, a solution including at least one of graphene, CNTs, and graphene oxide in addition to GQDs may be coated on the top surface of the semiconductor chip 540, and then dried. In this case, a heat dissipation film including GQDs and at least one of graphene, CNTs, and graphene oxide may be formed on the top surface of the semiconductor chip 540.

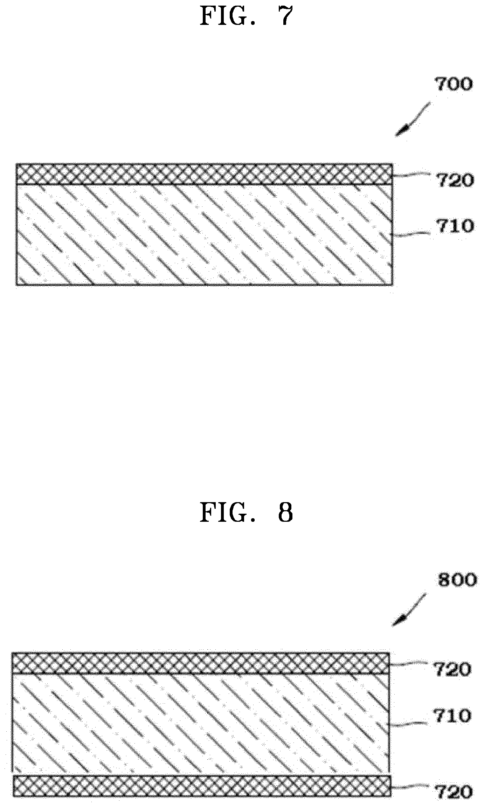

FIGS. 7 and 8 are cross-sectional views of energy conversion devices that include a heat-dissipation film according to some example embodiments.

Referring to FIG. 7, an energy conversion device 700 may include a heat dissipation film 720 on a surface of an energy generating element 710. In FIG. 7, the heat dissipation film 720 may be on an upper surface of the energy generating element 710, but the heat dissipation film 720 could alternatively be on a lower surface or a side surface of the energy generating element 710. The energy generating element 710 may be a solar cell or a battery, but is not limited thereto. The heat dissipation film 720 may be the same as any one of the heat dissipation films (e.g., heat dissipation films 120, 220, 320, 420, 520) discussed above.

Referring to FIG. 8, an energy conversion device 800 may be the same as the energy conversion device 700 in FIG. 7, except the energy conversion device 800 may include a heat dissipation film 720 on at least two surfaces of the energy generating element 710. For example, the heat dissipation film 720 may be on (and/or cover) an upper surface and a lower surface of the energy generating element 710.

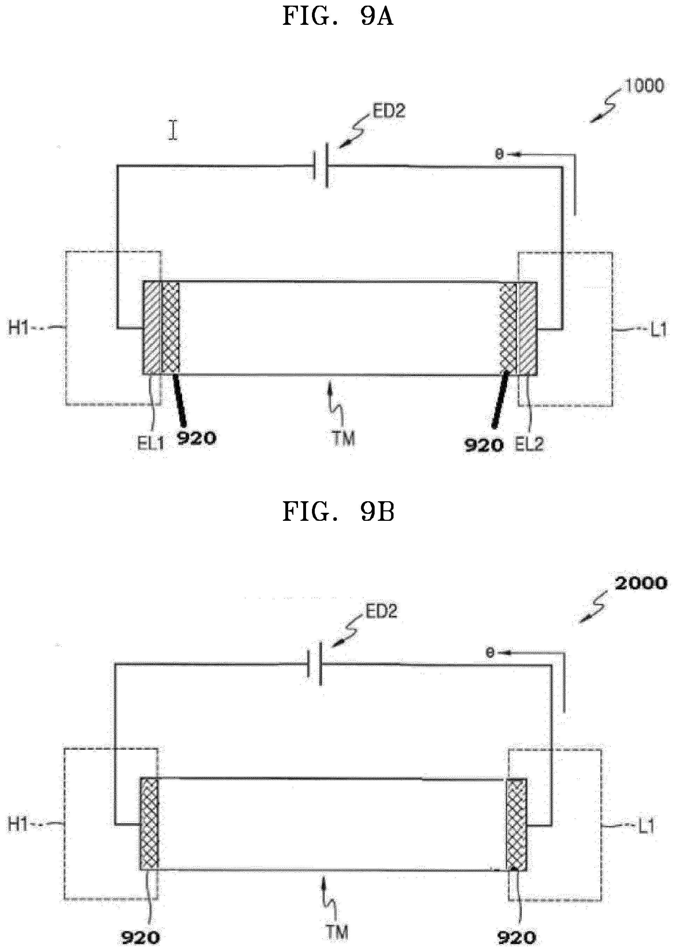

FIGS. 9A and 9B are cross-sectional views of thermoelectric devices that include a heat dissipation film according to some example embodiments.

Referring to FIG. 9A, a thermoelectric device 1000 may include a heat dissipation film 920 between a thermoelectric element TM and electrodes EL1 and

In some example embodiments, a plurality of semiconductor chips are produced by cutting a semiconductor wafer having mounted semiconductor devices thereon, and the heat dissipation film 520 is formed on the top surface of the semiconductor chip 540. However, alternatively, a heat dissipation structure may be produced by forming a heat dissipation film on a surface of a semiconductor wafer having mounted semiconductor devices thereon, and then cutting the semiconductor wafer.

According to the above-described embodiments, since a heat dissipation film including nano-sized graphene fragments (e.g., GQDs) is used, heat generated from a heating element such as a semiconductor chip may be efficiently dissipated to outside. In addition, since the heat dissipation film including the nano-sized graphene fragments (e.g., GQDs) is provided directly on a surface of the heating element without an adhesive layer intervening therebetween, heat dissipation properties may be improved and a heat dissipation structure such as a semiconductor package may have a small thickness.

## Claims

1. A heat dissipation structure (100) comprising:
a heating element (110); and
a heat dissipation film (120) on the heating element to dissipate heat generated from the heating element, to outside, the heat dissipation film including nano-sized graphene fragments;
**characterized in that** each of the nano-sized graphene fragments has at least one of:
a disc shape;
a thickness of 1 nm to 2 nm; and
a diameter of 3 nm to 4 nm.

2. The heat dissipation structure of claim 1, wherein the nano-sized graphene fragments comprise graphene quantum dots (GQDs).

3. The heat dissipation structure of claim 1 or 2, wherein the heat dissipation film further includes at least one of graphene, carbon nanotubes (CNTs) and graphene oxide.

4. The heat dissipation structure of any preceding claim, wherein
the heating element includes a semiconductor chip (340), and
the semiconductor chip includes one or more semiconductor devices (315) capable of generating heat due to operations thereof.

5. The heat dissipation structure of claim 4, wherein
the heat dissipation film (320) is on the semiconductor chip (340) to dissipate heat generated from the one or more semiconductor devices, to outside.

6. The heat dissipation structure of claim 4 or 5, wherein
the semiconductor chip (340) further includes a semiconductor substrate (310), and the semiconductor substrate is on the one or more semiconductor devices (315).

7. The heat dissipation structure of claim 6, wherein
a first surface of the semiconductor substrate (310) is on the one or more semiconductor devices (315), and
the heat dissipation film (320) is on a second surface of the semiconductor substrate opposite to the first surface.

8. The heat dissipation structure of claim 7, wherein the heat dissipation film (320) directly contacts the second surface of the semiconductor substrate.

9. The heat dissipation structure of claim 7 or 8, further comprising:
a package substrate (330) bonded to the semiconductor chip (340).

10. The heat dissipation structure of any preceding claim, wherein the heat dissipation film (320) has a thickness of 50 nm to 35 *µ*m.

11. A method of manufacturing a heat dissipation structure, the method comprising:
coating a solution including nano-sized graphene fragments on a surface of a heating element (110); and
forming a heat dissipation film (120) on the surface of the heating element by drying the solution including graphene fragments;
**characterized in that** the graphene fragments are nano-sized, and **in that** each of the graphene fragments has at least one of:
a disc shape;
a thickness of 1 nm to 2 nm; and
a diameter of 3 nm to 4 nm.

12. The method of claim 11, wherein the solution further includes at least one of graphene, carbon nanotubes (CNTs) and graphene oxide.

13. The method of claim 12, wherein the coating of the solution includes one of spin coating, screen printing, and a doctor blade method.

14. The method of any one of claims 11 to 13, of manufacturing a heat dissipation structure according to any one of claims 1 to 10.

## Patentansprüche

1. Wärmeableitungsstruktur (100), umfassend:
ein Heizelement (110); und
einen Wärmeableitungsfilm (120) auf dem Heizelement, um von dem Heizelement erzeugte Wärme nach außen abzuleiten, wobei der Wärmeableitungsfilm Graphenfragmente in Nanogröße enthält;
**dadurch gekennzeichnet, dass** jedes der Graphenfragmente in Nanogröße mindestens eines von Folgendem aufweist:
eine Scheibenform;
eine Dicke von 1 nm bis 2 nm; und
einen Durchmesser von 3 nm bis 4 nm.

2. Wärmeableitungsstruktur nach Anspruch 1, wobei die Graphenfragmente in Nanogröße Graphen-Quantenpunkte (graphene quantum dots - GQDs) umfassen.

3. Wärmeableitungsstruktur nach Anspruch 1 oder 2, wobei der Wärmeableitungsfilm ferner mindestens eines von Graphen, Kohlenstoffnanoröhren (carbon nanotubes - CNTs) und Graphenoxid enthält.

4. Wärmeableitungsstruktur nach einem vorhergehenden Anspruch, wobei das Heizelement einen Halbleiterchip (340) enthält, und
der Halbleiterchip eine oder mehrere Halbleitervorrichtungen (315) enthält, die in der Lage sind, aufgrund ihrer Operationen Wärme zu erzeugen.

5. Wärmeableitungsstruktur nach Anspruch 4, wobei
der Wärmeableitungsfilm (320) sich auf dem Halbleiterchip (340) befindet, um von der einen oder den mehreren Halbleitervorrichtungen erzeugte Wärme nach außen abzuleiten.

6. Wärmeableitungsstruktur nach Anspruch 4 oder 5, wobei
der Halbleiterchip (340) ferner ein Halbleitersubstrat (310) enthält und das Halbleitersubstrat sich auf der einen oder den mehreren Halbleitervorrichtungen (315) befindet.

7. Wärmeableitungsstruktur nach Anspruch 6, wobei
eine erste Oberfläche des Halbleitersubstrats (310) sich auf der einen oder den mehreren Halbleitervorrichtungen (315) befindet, und
der Wärmeableitungsfilm (320) sich auf einer zweiten Oberfläche des Halbleitersubstrats gegenüber der ersten Oberfläche befindet.

8. Wärmeableitungsstruktur nach Anspruch 7, wobei der Wärmeableitungsfilm (320) die zweite Oberfläche des Halbleitersubstrats direkt berührt.

9. Wärmeableitungsstruktur nach Anspruch 7 oder 8, ferner umfassend:
ein Gehäusesubstrat (330), das an den Halbleiterchip (340) gebunden ist.

10. Wärmeableitungsstruktur nach einem vorhergehenden Anspruch, wobei der Wärmeableitungsfilm (320) eine Dicke von 50 nm bis 35 *µ*m aufweist.

11. Verfahren zum Herstellen einer Wärmeableitungsstruktur, wobei das Verfahren umfasst:
Auftragen einer Lösung, die Graphenfragmente in Nanogröße enthält, auf eine Oberfläche eines Heizelements (110); und
Ausbilden eines Wärmeableitungsfilms (120) auf der Oberfläche des Heizelements durch Trocknen der Lösung, die Graphenfragmente enthält;
**dadurch gekennzeichnet, dass** die Graphenfragmente in Nanogröße vorliegen und dass jedes der Graphenfragmente mindestens eines von Folgendem aufweist:
eine Scheibenform;
eine Dicke von 1 nm bis 2 nm; und
einen Durchmesser von 3 nm bis 4 nm.

12. Verfahren nach Anspruch 11, wobei die Lösung ferner mindestens eines von Graphen, Kohlenstoffnanoröhren (CNTs) und Graphenoxid enthält.

13. Verfahren nach Anspruch 12, wobei das Auftragen der Lösung eines von Schleuderbeschichtung, Siebdruck oder ein Rakelverfahren enthält.

14. Verfahren nach einem der Ansprüche 11 bis 13 zum Herstellen einer Wärmeableitungsstruktur nach einem der Ansprüche 1 bis 10.

## Revendications

1. Structure de dissipation de chaleur (100) comprenant :
un élément chauffant (110) ; et
un film de dissipation de chaleur (120) sur l'élément chauffant pour dissiper la chaleur générée par l'élément chauffant vers l'extérieur, le film de dissipation de chaleur comprenant des fragments de graphène nanométriques ;
**caractérisé en ce que** chacun des fragments de graphène nanométriques possède au moins l'un parmi :
une forme de disque ;
une épaisseur de 1 nm à 2 nm ; et
un diamètre de 3 nm à 4 nm.

2. Structure de dissipation de chaleur selon la revendication 1, lesdits fragments de graphène nanométriques comprenant des points quantiques de graphène (GQD).

3. Structure de dissipation de chaleur selon la revendication 1 ou 2, ledit film de dissipation de chaleur comprenant en outre au moins l'un du graphène, des nanotubes de carbone (NTC) et de l'oxyde de graphène.

4. Structure de dissipation de chaleur selon une quelconque revendication précédente, ledit élément chauffant comprenant une puce semi-conductrice (340), et
ladite puce semi-conductrice comprenant un ou plusieurs dispositifs semi-conducteurs (315) capables de générer de la chaleur en raison de leurs fonctionnements.

5. Structure de dissipation de chaleur selon la revendication 4,
ledit film de dissipation de chaleur (320) étant sur la puce semi-conductrice (340) pour dissiper la chaleur générée par le ou les dispositifs semi-conducteurs vers l'extérieur.

6. Structure de dissipation de chaleur selon la revendication 4 ou 5,
ladite puce semi-conductrice (340) comprenant en outre un substrat semi-conducteur (310), et ledit substrat semi-conducteur se trouvant sur le ou les dispositifs semi-conducteurs (315).

7. Structure de dissipation de chaleur selon la revendication 6,
une première surface du substrat semi-conducteur (310) étant sur le ou les dispositifs semi-conducteurs (315), et
ledit film de dissipation de chaleur (320) étant sur une seconde surface du substrat semi-conducteur opposée à la première surface.

8. Structure de dissipation de chaleur selon la revendication 7, ledit film de dissipation de chaleur (320) entrant directement en contact avec la seconde surface du substrat semi-conducteur.

9. Structure de dissipation de chaleur selon la revendication 7 ou 8, comprenant en outre :
un substrat de boîtier (330) lié à la puce semi-conductrice (340).

10. Structure de dissipation de chaleur selon une quelconque revendication précédente, ledit film de dissipation de chaleur (320) possédant une épaisseur de 50 nm à 35 µm.

11. Procédé de fabrication d'une structure de dissipation de chaleur, le procédé comprenant :
la déposition d'une solution comprenant des fragments de graphène nanométriques sur une surface d'un élément chauffant (110) ; et
la formation d'un film de dissipation de chaleur (120) sur la surface de l'élément chauffant en séchant la solution comprenant des fragments de graphène ;
**caractérisé en ce que** les fragments de graphène sont nanométriques, et **en ce que** chacun des fragments de graphène possèdent au moins l'un parmi :
une forme de disque ;
une épaisseur de 1 nm à 2 nm ; et
un diamètre de 3 nm à 4 nm.

12. Procédé selon la revendication 11, ladite solution comprenant en outre au moins l'un du graphène, des nanotubes de carbone (NTC) et de l'oxyde de graphène.

13. Procédé selon la revendication 12, ledit revêtement de la solution comprenant l'un du revêtement par centrifugation, de la sérigraphie et d'un procédé à la racle.

14. Procédé selon l'une quelconque des revendications 11 à 13, de fabrication d'une structure de dissipation de chaleur selon l'une quelconque des revendications 1 à 10.
